# EUROPEAN PATENT APPLICATION

(11) **EP 4 084 080 A1**
(43) Date of publication of application: **02.11.2022**
(21) Application number: 20909008.3
(22) Date of filing: 30.12.2020
(51) Int. Cl.: H01L 27/32

(54) **DISPLAY SCREEN AND ELECTRONIC APPARATUS**

(30) Priority: 31.12.2019 CN 201911423250
(71) Applicant: GUANGDONG OPPO MOBILE TELECOMMUNICATIONS CORP., LTD., Dongguan, Guangdong 523860 (CN)
(72) Inventor: CUI, Zhijia, Dongguan, Guangdong 523860 (CN); SUN, Jingyang, Dongguan, Guangdong 523860 (CN); YU, Xiaofei, Dongguan, Guangdong 523860 (CN); YANG, Le, Dongguan, Guangdong 523860 (CN); JIA, Yuhu, Dongguan, Guangdong 523860 (CN)
(74) Representative: Mewburn Ellis LLP
(86) International application number: PCT/CN2020/141509
(87) International publication number: WO 2021/136409

(57) **Abstract**

A display screen (100) and an electronic device are provided. The display screen (100) includes a metal anode layer (1), a semi-transparent cathode layer (2), and a pixel unit layer (3). The metal anode layer (1) includes multiple metal anodes (11) arranged at intervals. The semi-transparent cathode layer (2) includes multiple semi-transparent cathodes (21). The pixel unit layer (3) is sandwiched between the metal anode layer (1) and the semi-transparent cathode layer (2). The pixel electrode layer (3) includes multiple pixel units (31) arranged at intervals. Each pixel unit (31) is located between a corresponding metal anode (11) and a corresponding semi-transparent cathode (21). In a preset region of the display screen (100), the semi-transparent cathode layer (2) further includes a light-shielding portion (22) and light-transmitting regions (23) surrounded by the light-shielding portion (22). The light-shielding portion (22) is disposed between or on the multiple semi-transparent cathodes (21). The light-transmitting region (23) is disposed in the preset region to allow light to pass through the display screen (100) without a non-display region reserved for holing.

## Description

### TECHNICAL FIELD

This application relates to the technical field of electronic apparatus, and in particular, to an electronic device and a sound control method thereof.

### BACKGROUND

Currently, full-screen electronic devices are becoming more and more mainstream due to their high screen-to-body ratio, which can significantly increase a size of a display region of a display screen without additionally increasing a size of the whole device. Nowadays, when achieving a high screen-to-body ratio, a problem that the full-screen electronic device needs to face is how to maintain normal operations of both a front camera and sensors located at a front screen.

At present, the full-screen electronic device is typically realized in two ways. The first way is to reserve a non-display region in a notch type or a water-drop notch type in the display screen for accommodation of components such as the front camera and sensors. The second way is to arrange the components such as the front camera and sensors in a pop-up/rotating structure, when needed, such structure can be popped out or rotated out from a body of the full-screen electronic device to allow the components such as the front camera and sensors to be exposed to perform corresponding operations. However, for the first way, reservation of the non-display region limits a further increase in the screen-to-body ratio; for the second way, the pop-up/rotating structure is prone to be damaged due to collision after being popped up.

Therefore, it is desirable to provide an improved full-screen solution.

### SUMMARY

A display screen and an electronic device are provided in implementations of the disclosure to resolve the above problems.

In an aspect, a display screen is provided. The display screen includes a metal anode layer, a semi-transparent cathode layer, and a pixel unit layer. The metal anode layer includes multiple metal anodes arranged at intervals. The semi-transparent cathode layer includes multiple semi-transparent cathodes. The pixel unit layer is sandwiched between the metal anode layer and the semi-transparent cathode layer. The pixel electrode layer includes multiple pixel units arranged at intervals. Each pixel unit is located between a corresponding metal anode and a corresponding semi-transparent cathode. In a preset region of the display screen, the semi-transparent cathode layer further includes a light-shielding portion and light-transmitting regions surrounded by the light-shielding portion. The light-shielding portion is disposed between or on the multiple semi-transparent cathodes.

In another aspect, an electronic device is provided. The electronic device includes a display screen. The display screen includes a metal anode layer, a semi-transparent cathode layer, and a pixel unit layer. The metal anode layer includes multiple metal anodes arranged at intervals. The semi-transparent cathode layer includes multiple semi-transparent cathodes. The pixel unit layer is sandwiched between the metal anode layer and the semi-transparent cathode layer. The pixel electrode layer includes multiple pixel units arranged at intervals. Each pixel unit is located between a corresponding metal anode and a corresponding semi-transparent cathode. In a preset region of the display screen, the semi-transparent cathode layer further includes a light-shielding portion and light-transmitting regions surrounded by the light-shielding portion. The light-shielding portion is disposed between or on the multiple semi-transparent cathodes.

In this disclosure, in the preset region of the display screen, the light-transmitting region is disposed in the semi-transparent cathode layer to allow light to pass through the display screen. When the display screen is used in an electronic device, photosensitive components arranged on an inner side of the display screen can operate normally without a non-display region reserved for holing, which significantly increases a screen-to-body ratio of the display screen.

### BRIEF DESCRIPTION OF THE DRAWINGS

In order to describe technical solutions of implementations of the disclosure or the related art more clearly, the following will give a brief introduction to the accompanying drawings used for describing the implementations or the related art. Apparently, the accompanying drawings hereinafter described are merely some implementations of the disclosure. Based on these drawings, those of ordinary skill in the art can also obtain other drawings without creative effort.
FIG. 1 is a schematic cross-sectional view of part of a display screen in an implementation of the disclosure.
FIG. 2 is a top view of a preset region of a display screen in an implementation of the disclosure.
FIG. 3 is a top view of a preset region of a display screen in another implementation of the present application.
FIG. 4 is a top view of a preset region of a display screen in yet another implementation of the disclosure.
FIG. 5 is a schematic cross-sectional view of part of a display screen in another implementation of the disclosure.
FIG. 6 is a schematic cross-sectional view of part of a display screen in yet another implementation of the disclosure.
FIG. 7 is a schematic cross-sectional view of part of a display screen in other implementations of the disclosure.
FIG. 8 is a top view of an overall display screen in an implementation of the disclosure.
FIG. 9 is a top view of an overall display screen in another implementation of the disclosure.
FIG. 10 is a structural block diagram of an electronic device in an implementation of the disclosure.
FIG. 11 is a schematic cross-sectional view illustrating part of elements of an electronic device in an implementation of the disclosure.

### DETAILED DESCRIPTION

In order to enable those skilled in the art to better understand solutions of the disclosure, technical solutions in implementations of the disclosure will be described clearly and completely hereinafter with reference to the accompanying drawings in the implementations of the disclosure. Apparently, the described implementations are merely some rather than all implementations of the disclosure. All other implementations obtained by those of ordinary skill in the art based on the implementations of the disclosure without creative efforts shall fall within the protection scope of the disclosure.

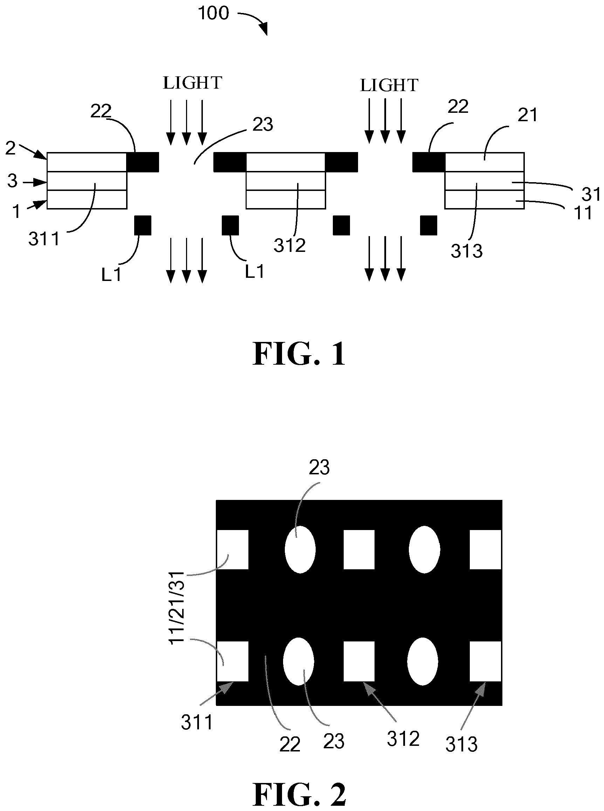

Referring to FIG. 1, which is a schematic cross-sectional view of part of a display screen 100 in an implementation of the disclosure. The display screen 100 includes a metal anode layer 1, a semi-transparent cathode layer 2, and a pixel unit layer 3. The metal anode layer 1 includes multiple metal anodes 11 arranged at intervals. The semi-transparent cathode layer 2 includes multiple semi-transparent cathodes 21. The pixel unit layer 3 is sandwiched between the metal anode layer 1 and the semi-transparent cathode layer 2. The pixel electrode layer 3 includes multiple pixel units 31 arranged at intervals. Each pixel unit 31 is located between a corresponding metal anode 11 and a corresponding semi-transparent cathode 21. In a preset region of the display screen 100, the semi-transparent cathode layer 2 further includes a light-shielding portion 22 and light-transmitting regions 23 surrounded by the light-shielding portion 22. The light-shielding portion 22 is disposed between or on the multiple semi-transparent cathodes 21.

As such, in this disclosure, in the preset region of the display screen 100, the light-transmitting region 23 is disposed in the semi-transparent cathode layer 2 to allow light to pass through the display screen 100. When the display screen 100 is used in an electronic device, photosensitive components arranged on the inner side of the display screen 100 can operate normally without a non-display region reserved for holing, which significantly increases a screen-to-body ratio of the display screen 100.

In an implementation, the light shielding portion 22 is used to shield traces around the pixel unit 31 to reduce diffraction caused by the traces, and cooperates with the light-transmitting regions 23 to ensure an amount of light passing through.

In this disclosure, the light-shielding portion 22 is disposed on the semi-transparent cathode 21, which means that the light-shielding portion 22 is carried on or attached to the semi-transparent cathode 21, and is not limited to above the semi-transparent cathode 21 in terms of position or orientation.

In an implementation, the display screen 100 is used for display, for example, displaying corresponding display content for a user to view. The semi-transparent cathode layer 2 is close to a viewing surface of the display screen 100 for the user to view.

In an implementation, the light-transmitting regions 23 are hollow or made of a fully transparent material.

That is, in some implementations, the light-transmitting regions 23 are hollow regions formed by one or more through-holes penetrating through the semi-transparent cathode layer 2, or the light-transmitting regions 23 may be regions formed by further filling the one or more through-holes penetrating through the semi-transparent cathode layer 2 with fully transparent material. In an implementation, the fully transparent material may be fully transparent glass, resin, and other materials.

Referring to FIG. 2, which is a top view of the preset region of the display screen 100. As illustrated in FIG. 2, in the preset region, the light-shielding portion 22 is disposed between or on adjacent semi-transparent cathodes 21. The light-shielding portion 22 disposed between or on the adjacent semi-transparent cathodes 21 surrounds the light-transmitting regions 23. Thus, the semi-transparent cathode layer 2 includes multiple light-transmitting regions 23 in the preset region.

As such, the light-transmitting regions 23 are staggered with the pixel units 31 sandwiched between the semi-transparent cathodes 21 and the metal anodes 11, so that display of the preset region will not be affected, and light can pass through the preset region to allow elements such as photosensitive components to achieve corresponding functions.

In an implementation, the semi-transparent cathode 21, the metal anode 11, and the pixel unit 31 are stacked in a direction perpendicular to a plane of the display screen 100. Thus, in the top view illustrated in FIG. 2, the semi-transparent cathode 21, the metal anode 11, and the pixel unit 31 are in the same region.

In an implementation, the photosensitive components may be luminance/light sensors, camera lens modules, and the like.

In an implementation, as illustrated in FIG. 1, the light-shielding portion 22 between or on the adjacent semi-transparent cathodes 21 is used to shield metal traces L1 around the pixel units 31 corresponding to the semi-transparent cathodes 21. The light-shielding portion 22 extends according to arrangement positions of the metal traces L1 that need to be shielded.

In some implementations, the light-shielding portion 22 extends to shield a metal-trace L1 region around corresponding pixel units and further extends to have a boundary line in a specific shape, and the light-transmitting region 23 is surrounded by the boundary line and thus has the specific shape. For example, the light-transmitting region 23 is circular, oval, or rectangular. That is, in some implementations, a projection of the metal-trace region on the light-shielding portion 22 falls within the light-shielding portion 22. The light-shielding portion 22 extends to shield the metal-trace L1 region around the corresponding pixel units and then further extends to ensure that the metal traces are completely shielded.

In other implementations, the light-shielding portion 22 extends to exactly shield the metal-trace L1 region around the corresponding pixel units, and the light-transmitting region 23 is a region with edges of the metal-trace L1 region as a boundary line. That is, in another implementation, the projection of the metal-trace L1 region on the light-shielding portion 22 approximately coincides with the light-shielding portion 22, and the boundary line of the light-transmitting region 23 surrounded by the light-shielding portion 22 is approximately the same as edges of the metal traces, which makes the light-transmitting region 23 a region with the edges of the metal-trace L1 region as a boundary line. Here, the light-transmitting region 23 can have a maximum area, which effectively improves a light transmittance in the preset region.

In an implementation, as illustrated in FIG. 1 and FIG. 2, the pixel unit 31 may include a red pixel unit 311, a green pixel unit 312, and a blue pixel unit 313. The red pixel unit 311, the green pixel unit 312, and the blue pixel unit 313 constitute a pixel. The display screen 100 includes multiple pixels arranged in a matrix.

As illustrated in FIG. 1 and FIG. 2, light-transmitting regions 23 are disposed between adjacent pixel units 31. The light-transmitting regions 23 are disposed between adjacent red pixel unit 311 and green pixel unit 312, between adjacent green pixel unit 312 and blue pixel unit 313, and between adjacent blue pixel unit 313 and red pixel unit 311.

As illustrated in FIG. 2, the light-transmitting regions 23 and the pixel units 31 are arranged in a same row.

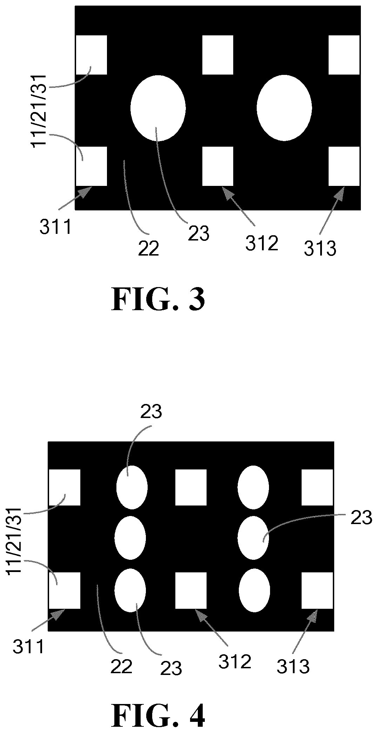

Referring to FIG. 3, which is a schematic top view of a preset region of a display screen 100 in another implementation. In another implementation, a light-transmitting region 23 may also be disposed in a rectangular region with four adjacent pixel units 31 in two adjacent rows as vertices. In an implementation illustrated in FIG. 3, spacing between adjacent pixel units 31 can be reduced and thus a resolution can be improved. In addition, the light-transmitting region 23 is disposed between four pixel units, and thus can be set as large as possible without having a relatively great impact on an overall light transmission effect.

Referring to FIG. 4, which is a schematic top view of a preset region of a display screen 100 in yet another implementation. In yet another implementation, light-transmitting regions 23 can be disposed in regions between adjacent pixel units 31 and in rectangular regions each with four adjacent pixel units 31 in two adjacent rows as vertices. That is, as illustrated in FIG. 4, some light-transmitting regions 23 are disposed between adjacent pixel units 31, and some other light-transmitting regions 23 are disposed in the rectangular regions each with adjacent four pixel units 31 in two adjacent rows as vertices.

As such, light-transmitting regions 23 are disposed in rectangular regions each with four adjacent pixel units 31 in two adjacent rows as vertices and regions between adjacent pixel units 31, which effectively improves the light transmission effect.

Referring back to FIG. 1, in some implementations, each semi-transparent cathode 21 has a same size as each pixel unit 31. The light-shielding portion 22 includes an opaque cathode 221 which is disposed between and coplanar with multiple semi-transparent cathodes 21. The light-transmitting regions 23 are hollow regions surrounded by the opaque cathode 221 or are formed by filling the hollow regions with a fully transparent material.

That is, in some implementations, as illustrated in FIG. 1, the light-shielding portion 22 is the opaque cathode 221 disposed between the multiple semi-transparent cathodes 21. The opaque cathode 221 surrounds the light-transmitting regions 23. The opaque cathode 221 shields the metal traces L1.

Further, in some implementations, the semi-transparent cathodes 21 may be first patterned on each pixel unit 31, the opaque cathode 221 is then patterned on a layer where the semi-transparent cathodes 21 are arranged, and the opaque cathode 221 and the semi-transparent cathodes 21 are connected to corporately form a complete semi-transparent cathode layer 2. One or more through-holes are then defined in a region of the opaque cathode 221 that does not correspond to the metal traces L1 (e.g., the region between adjacent pixel units 31 and the rectangular region with four adjacent pixel units 31 in two adjacent rows as vertices) to form hollow regions as the light-transmitting regions 23, or the hollow regions are further filled with a fully transparent material to form the light-transmitting regions 23, and the rest of the opaque cathode 221 that surrounds the light-transmitting regions 23 servers as the light-shielding portion 22 to shield the metal traces L1.

In an implementation, both the semi-transparent cathode 21 and the opaque cathode 221 can be patterned via vapor deposition.

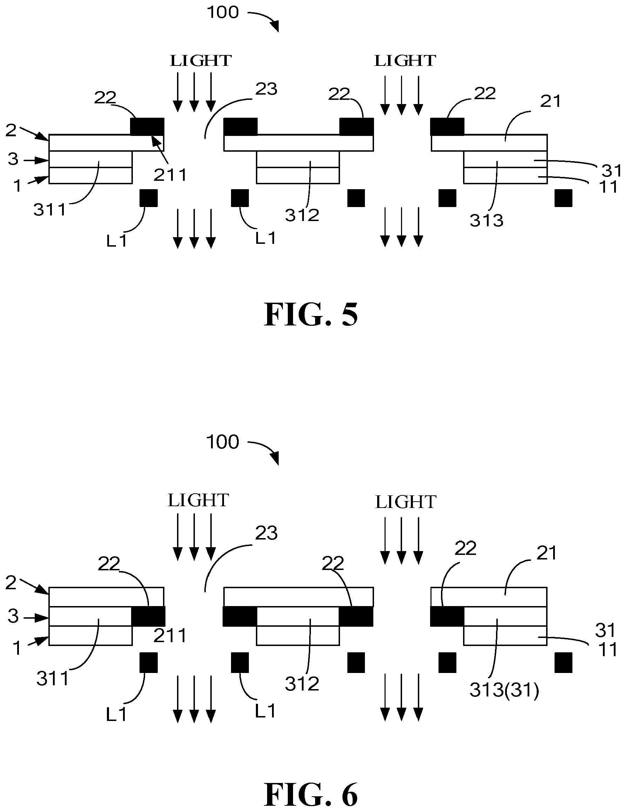

Referring to FIG. 5, which is a schematic cross-sectional view of part of a display screen 100 in another implementation. As illustrated in FIG. 5, each semi-transparent cathode 21 has a size larger than a pixel unit 31 corresponding to the semi-transparent cathode 21. A projection of each pixel unit 31 on the corresponding semi-transparent cathode 21 falls within the semi-transparent cathode 21. The light-shielding portion 22 is stacked on a surface of an edge region 211 of the semi-transparent cathode 21. The edge region 211 is a region beyond a projection region of the pixel unit 31 on the semi-transparent cathode 21. The edge region 211 extends according to arrangement positions of metal traces L1 that need to be shielded. As illustrated in FIG. 5, the light-transmitting regions 23 are surrounded by the light-shielding portion 22 and the semi-transparent cathode 21 stacked with the light-shielding portion 22.

That is, in the other implementation, the light-shielding portion 22 is stacked on the semi-transparent cathode 21.

The projection of each pixel unit 31 on the corresponding semi-transparent cathode 21 falls within the semi-transparent cathode 21, which can means that any point on a boundary of the projection of each pixel unit 31 on the corresponding semi-transparent cathode 21 is at a certain distance from the semi-transparent cathode 21. As such, the projection of each pixel unit 31 on the corresponding semi-transparent cathode 21 completely falls within the corresponding semi-transparent cathode 21, and the edge region 211 of the semi-transparent cathode 21 surrounds edges of the semi-transparent cathode 21.

In an implementation, the light-shielding portion 22 is disposed on a surface of the edge region of the semi-transparent cathode 21 close to the pixel unit 31; or the light-shielding portion 22 is disposed on a surface of the edge region of the semi-transparent cathode 21 away from the pixel unit 31.

In an implementation, a semi-transparent cathode 21 with a size larger than the pixel unit 31 may be first patterned on each pixel unit 31, and then the light-shielding portion 22 may be patterned on a surface of the edge region 211 of the semi-transparent cathode 21.

In an implementation, both the semi-transparent cathode 21 and the light-shielding portion 22 can be patterned via vapor deposition.

For example, as illustrated in FIG. 5, the light-shielding portion 22 is disposed on the surface of the edge region of the semi-transparent cathode 21 away from or opposite to the pixel unit 31.

Referring to FIG. 6, which is a schematic cross-sectional view of part of a display screen 100 in yet another implementation. In yet another implementation, the light-shielding portion 22 is disposed on a surface of the edge region of the semi-transparent cathode 21 close to or toward the pixel unit 31.

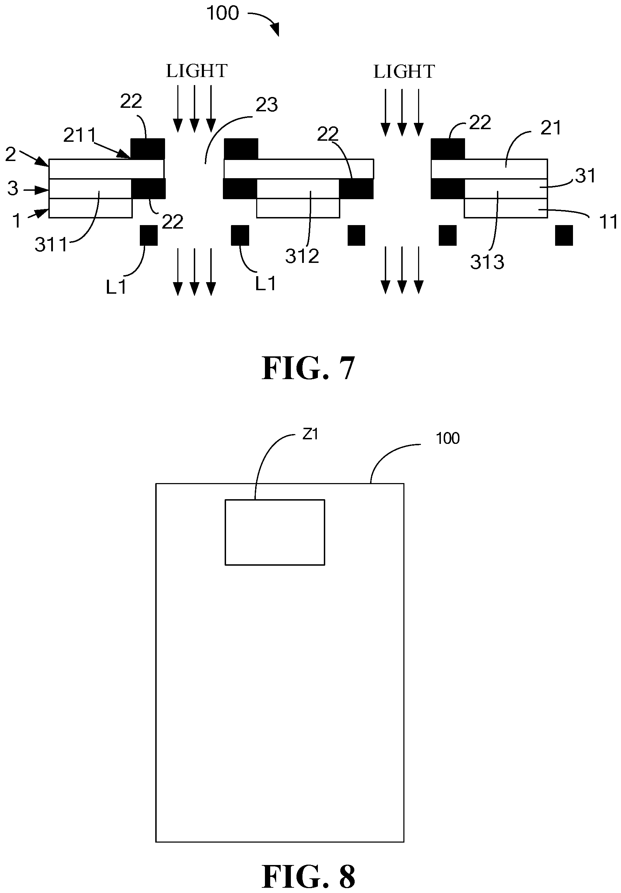

Referring to FIG. 7, which is a schematic cross-sectional view of part of a display screen 100 in other implementations of the disclosure. In other implementations, the light-shielding portions 22 can be disposed on both the surface of the edge region 211 of the semi-transparent cathode 21 close to the pixel unit 31 and the surface of the edge region of the semi-transparent cathode 21 away from the pixel unit 31. Further, the light-shielding portion 22 disposed on the surface of the edge region 211 of the semi-transparent cathode 21 close to the pixel unit 31 is symmetrical to the light-shielding portion 22 disposed on the surface of the edge region 211 of the semi-transparent cathode 21 away from the pixel unit 31.

That is, in other implementations, light-shielding portions 22 are disposed on the surface of the edge region 211 of each semi-transparent cathode 21 close to the pixel unit 31 and the surface of the edge region 211 of each semi-transparent cathode 21 away from the pixel unit 31, and the light-shielding portions 22 on the two surfaces are symmetrically arranged.

In some implementations, the light-shielding portions 22 are disposed on surfaces of edge regions 211 of part of the semi-transparent cathodes 21 close to the pixel unit 31, on surfaces of edge regions of another part of the semi-transparent cathode 21 away from the pixel unit 31, and on surfaces of edge regions of the rest of the semi-transparent cathodes 21 close to the pixel unit 31 and surfaces of the edge regions 211 of the rest of the semi-transparent cathodes 21 away from the pixel unit 31.

That is, the light-shielding portions are disposed on two opposite surfaces of the edge region 211 of the semi-transparent cathode.

In an implementation, when the light-shielding portion 22 is disposed on the surface of the edge region 211 of the semi-transparent cathode 21, the light-shielding portion 22 can be formed on the surface of the edge region 211 of the semi-transparent cathode 21 via evaporation.

In an implementation, as illustrated in FIGS. 5-7, when the light-shielding portion 22 is disposed on the surface of the edge region 211 of the semi-transparent cathode 21, the light-shielding portion 22 is made of an opaque material or a semi-transparent material.

For example, the light-shielding portion 22 can also be a semi-transparent cathode 21. The light-shielding portion 22 stacked on the semi-transparent cathode 21 thickens the semi-transparent cathode 21 in the edge region 211, and an opaque effect is achieved through the thickened semi-transparent cathode 21, thereby shielding the metal traces L1 below.

For another example, the light-shielding portion 22 can also be an opaque cathode. The light-shielding portion 22 is stacked on the semi-transparent cathode 21 to shield the metal traces L1 below.

In an implementation, the semi-transparent cathode 21 can be made of a semi-transparent indium tin oxide material or a semi-transparent metal material. A light transmittance of the semi-transparent cathode 21 is 50%. The opaque cathode can be made of opaque metal or other materials.

In an implementation, the display screen of the disclosure may be an organic light-emitting diode (OLED) display screen. As illustrated in figures such as FIGS. 1 and 5-7, each pixel unit 31 is sandwiched between one semi-transparent cathode 21 and one metal anode 11. All semi-transparent cathodes 21 can serve as a common electrode to be grounded and at a voltage of 0 V Each metal anode 11 serves as a pixel electrode and is connected with a driving circuit (not illustrated), and the driving circuit applies a corresponding driving voltage to the corresponding metal anode 11 according to data of contents to be displayed, so that the metal anode 11 drives the pixel unit 31 to emit light of a corresponding color, which in turn enables the display screen 100 to display corresponding contents.

In an implementation, the metal anode 11 in the metal anode layer 1 may be made of an opaque metallic material.

As illustrated in figures such as FIGS. 1 and 5-7, adjacent metal anodes 11 are spaced by a gap and adjacent pixel units 31 are spaced by a gap. Each light-transmitting region 23 communicates with the gap between corresponding metal anodes 11 and the gap between corresponding pixel units 31. A projection of the gap between the pixel units 31 in a direction from the semi-transparent cathode layer 2 to the metal anode layer 1 overlaps or partially overlaps with the gap between the metal anodes 11. A projection of the light-transmitting region 23 in a direction from the semi-transparent cathode layer 2 to the metal anode layer 1 falls within the gap between the metal anodes 11 and the gap between the pixel units 31.

As such, the light-transmitting region 23, the gap between the pixel units 31, and the gap between the metal anodes 11 form an optical path channel. When photosensitive components are arranged on an inner side (that is, a non-viewing surface) of the display screen 100, light can enter the photosensitive components through the light-transmitting region 23, the gap between the pixel units 31, and the gap between the metal anodes 11 in sequence, and corresponding functions of the photosensitive components can be realized.

In an implementation, only six pixel units 31 in two rows and corresponding six metal anodes 11 and six semi-transparent cathodes 21 are illustrated in FIGS. 1 and 5-7. It is noted that, in the preset region, multiple pixel units 31, multiple corresponding metal anodes 11, and multiple corresponding semi-transparent cathodes 21 can be provided. Further, as illustrated in FIG. 1 and 5-7, in terms of the semi-transparent cathodes 21 located at the two outermost sides, no shielding portion 22 is disposed at one end of the semi-transparent cathode 21 that does not adjacent to any other semi-transparent cathode 21, and thus no shielding portion 22 is required.

Referring to FIG. 8, which is a top view of an overall display screen 100. As illustrated in FIG. 8, the display screen 100 has a preset region Z1. The display screen 100 may be in a substantially rectangular shape and have two opposite long sides and two opposite short sides. The preset region Z1 may be close to a short side of the display screen 100.

In an implementation, a pixel resolution of the preset region Z1 is lower than that of other regions of the display screen 100. As such, the number of pixel units 31 in the preset region Z1 will be reduced by lowing the pixel resolution of the preset region Z1, which can reserve a region for arrangement of the light-transmitting regions 23 to allow light to pass through.

In an implementation, a difference in pixel resolution between the preset region Z1 and other regions of the display screen 100 is within a difference range that is indistinguishable to the naked eye. For example, the display screen 100 has a pixel resolution of 1920×1080 in a region beyond the preset region Z1 and a resolution of 1280×720 in the preset region Z1, such that more region can be reserved for arrangement of the light-transmitting regions 23, and the difference in resolution is indistinguishable the naked eye and therefore will not affect a visual effect for the user.

In an implementation, as illustrated in FIG. 8, the display screen 100 includes only one preset region Z1 which is disposed close to a short side of the display screen 100. The preset region Z1 is spaced apart from each side of the display screen 100 by a certain distance.

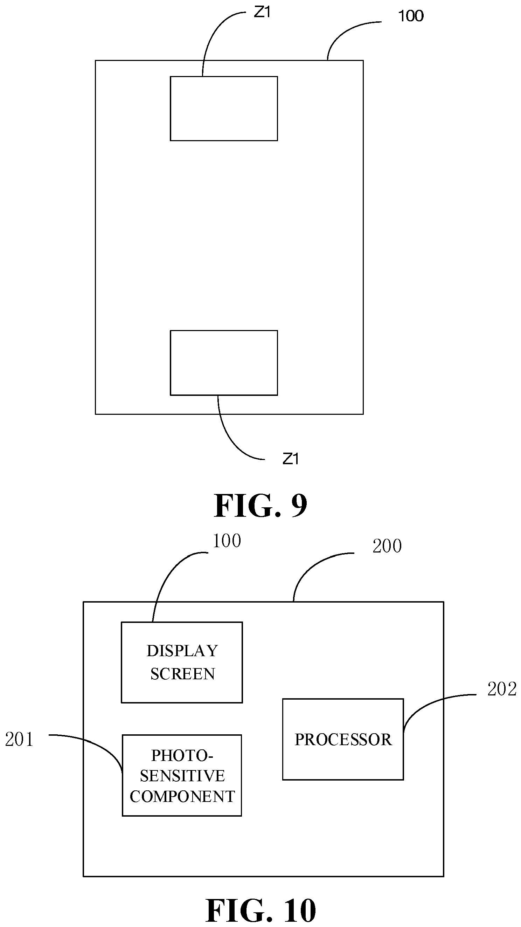

Referring to FIG. 9, which is a top view of an overall display screen 100 in another implementation. In another implementation, the display screen 100 may include two preset regions Z1. For example, as illustrated in FIG. 9, the two preset regions Z1 are respectively disposed close to two opposite short sides. Each of the two preset regions Z1 has the aforementioned structures such as the metal anode layer 1, the semi-transparent cathode layer 2, the pixel unit layer 3, and the light-transmitting region 23.

By arranging the preset regions Z1 at two opposite short sides of the display screen 100, when the display screen 100 is applied to an electronic device, photosensitive components such as camera lenses of a camera assembly can be arranged at positions corresponding to the two preset regions Z1 of the electronic device, and a wide-angle shooting can be realized.

In an implementation of the disclosure, the light-transmitting region 23 is only disposed in the preset region Z1 and not disposed in other regions of display screen 100, and the other regions can have the same structure as an ordinary OLED display screen.

In some implementations, the light-shielding portion 22 can be formed in all regions of the display screen 100 to shield the metal traces L1 around all pixel units 31 of the display screen 100. In other implementations, the light-shielding portion 22 can also be disposed only in the preset region Z1. The metal traces L1 can be shielded by means of black matrixes or the like in other regions of the display screen 100 beyond the preset region Z1, which is the same as an ordinary OLED display screen in structure.

In an implementation, the display screen 100 can also include a cover plate. The cover plate is disposed on the semi-transparent cathode layer 2. That is, the cover plate is disposed on a side of the semi-transparent cathode layer 2 away from the pixel unit layer 3, to protect the display screen 100. The cover plate may be made of fully transparent glass, resin, or the like.

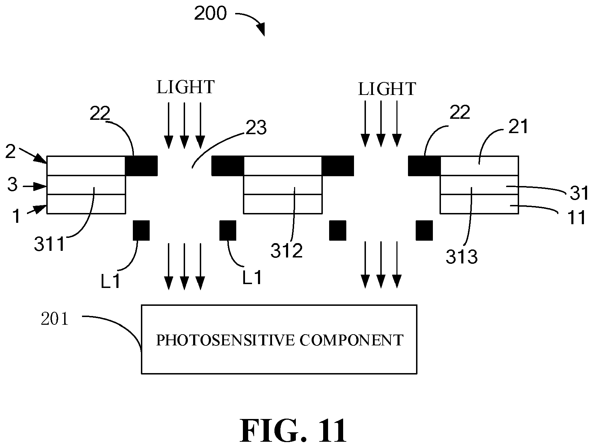

Referring to FIG. 10 and FIG. 11, FIG. 10 is a structural block diagram of an electronic device 200 in an implementation of the disclosure, and FIG. 11 is a schematic cross-sectional view illustrating part of elements of an electronic device 200. The electronic device 200 includes the display screen 100 described in any of the foregoing implementations. The electronic device 200 further includes a photosensitive component 201.

In an implementation, as illustrated in FIG. 11, the photosensitive component 300 is disposed in the electronic device 200 and corresponds to the preset region Z1 of the display screen 100.

Specifically, as described above, adjacent metal anodes 11 are spaced by a gap and adjacent pixel units 31 are spaced by a gap. Each light-transmitting region 23 in the present region Z1 communicates with the gap between corresponding metal anodes 11 and the gap between corresponding pixel units 31. A projection of the gap between the pixel units 31, in a direction from the semi-transparent cathode layer 2 to the metal anode layer 1, overlaps or partially overlaps with the gap between the metal anodes 11. A projection of the light-transmitting region 23 in a direction from the semi-transparent cathode layer 2 to the metal anode layer 1 falls within the gap between the metal anodes 11 and the gap between the pixel units 31.

As such, the light-transmitting region 23, the gap between the pixel units 31, and the gap between the metal anodes 11 form an optical path channel. Light can enter the photosensitive component 201 through the light-transmitting region 23, the gap between the pixel units 31, and the gap between the metal anodes 11 in sequence, which such that the photosensitive component 300 can realize corresponding functions by sensing light to generate a corresponding photosensitive signal.

In an implementation, a size of a photosensitive surface of the photosensitive component 201 can be approximately the same as a size of the preset region Z1, and the light passing through all light-transmitting regions 23 of the preset region Z1 can be received by the photosensitive component 201.

In some implementations, the photosensitive component 201 includes at least one of a light sensor or a camera lens module.

In an implementation, the camera lens module may include a camera lens and an image sensor.

As illustrated in FIG. 10, the electronic device 200 further includes a processor 202. The processor 202 is connected to the photosensitive component 201 and used to perform corresponding functions according to a light-sensing signal generated by the photosensitive component 201.

In an implementation, when the photosensitive component 201 is a light sensor, it generates a corresponding light-sensing signal upon receiving external light. The processor 202 receives the light-sensing signal to determine an external ambient brightness, and can control to automatically adjust a display brightness of the display screen 100.

When the photosensitive component 201 is a camera lens module, it receives external light to generate a corresponding image light-sensing signal, and the processor 202 receives the image light-sensing signal to perform imaging processing.

In some implementations, when there are two preset regions Z1, for example, as mentioned above, the preset regions Z1 are respectively disposed at positions close to two opposite short sides of the display screen 100. The electronic device 200 of the disclosure is a full-screen display screen, and thus a size of the display screen 100 is approximately the same as a size of the electronic device 200 on a plane of the display screen 100. The two preset regions Z1 are also respectively disposed at positions of two opposite short sides of the electronic device 200. Correspondingly, there are at least two photosensitive components 300, which are respectively disposed corresponding to the two preset regions Z1.

When the photosensitive component 201 is a light sensor, it can generate corresponding light-sensing signals at positions of two opposite short sides of the electronic device 200, so that more accurate detection of ambient brightness can be realized. The processor 202 can eventually determine the ambient brightness according to the light-sensing signals generated by the at least two photosensitive components 300, and control and adjust the display brightness of the display screen 100 according to the eventually determined ambient brightness, and thus more accurate adjustment can be achieved.

When the photosensitive component 201 is a camera lens module, it can generate corresponding image light-sensing signals by respectively collecting light at positions of the two opposite short sides of the electronic device 200, which can realize wide-angle photography or depth photography. Specifically, the processor 202 can obtain a wide-angle image or a depth image according to the image light-sensing signals generated by the at least two photosensitive components 300, and obtain more types of images to meet more needs of users.

In an implementation, the processor 202 may be a processor integrated with an image processor, and the like. Specifically, the processor 202 may be a central processing unit, a digital signal processor, a single-chip microcomputer, and the like.

The electronic device 200 can be an electronic device with a display screen and a photosensitive component, such as a mobile phone, a tablet computer, a digital camera, and the like.

Therefore, in this disclosure, in the preset region of the display screen 100, the light-transmitting regions 23 are disposed in the semi-transparent cathode layer 2 to allow light to pass through the display screen 100. When the display screen 100 is used in the electronic device 200, photosensitive components 201 arranged on the inner side of the display screen 100 can operate normally without a non-display region reserved for holing, which significantly increases the screen-to-body ratio of the display screen 100.

It is to be noted that, for the sake of simplicity, the foregoing method implementations are described as a series of action combinations, however, it will be appreciated by those skilled in the art that the disclosure is not limited by the sequence of actions described. According to this disclosure, certain steps or operations may be performed in other order or simultaneously. Besides, it will be appreciated by those skilled in the art that the implementations described in the specification are exemplary implementations and the actions and modules involved are not necessarily essential to the disclosure.

In the foregoing implementations, the description of each implementation has its own emphasis. For the parts not described in detail in one implementation, reference may be made to related descriptions in other implementations.

The implementations of the present invention are introduced in detail in the foregoing, and specific examples are applied here to set forth the principle and the implementation of the present invention, and the foregoing illustration of the implementations is only to help in understanding the method and the core idea of the present invention. Meanwhile, those of ordinarily skill in the art may make variations and modifications to the present invention in terms of the implementations and application scopes according to the ideas of the present invention. Therefore, the specification shall not be construed as limitations to the present invention.

## Claims

1. A display screen, comprising:
a metal anode layer, comprising a plurality of metal anodes arranged at intervals;
a semi-transparent cathode layer, comprising a plurality of semi-transparent cathodes; and
a pixel unit layer, sandwiched between the metal anode layer and the semi-transparent cathode layer, wherein the pixel electrode layer comprises a plurality of pixel units arranged at intervals, and each pixel unit is located between a corresponding metal anode and a corresponding semi-transparent cathode;
in a preset region of the display screen, the semi-transparent cathode layer further comprises a light-shielding portion and light-transmitting regions surrounded by the light-shielding portion, the light-shielding portion being disposed between or on the plurality of semi-transparent cathodes.

2. The display screen of claim 1, wherein the light-transmitting regions are hollow or made of a fully transparent material.

3. The display screen of claim 2, wherein
in the preset region of the display screen, the light-shielding portion is disposed between or on adjacent semi-transparent cathodes, and the light-shielding portion disposed between or on the adjacent semi-transparent cathodes surrounds the light-transmitting regions; and
the semi-transparent cathode layer comprises a plurality of light-transmitting regions in the preset region.

4. The display screen of claim 3, wherein the light-shielding portion between or on the adjacent semi-transparent cathodes is used to shield metal traces around the pixel units corresponding to the semi-transparent cathodes.

5. The display screen of claim 4, wherein
the light-shielding portion extends to shield a metal-trace region around corresponding pixel units and further extends to have a boundary line in a specific shape, and the light-transmitting region is surrounded by the boundary line and has the specific shape; or
the light-shielding portion extends to exactly shield the metal-trace region around the corresponding pixel units, and the light-transmitting region is a region with edges of the metal-trace region as a boundary line.

6. The display screen of any of claims 2-5, wherein
each semi-transparent cathode has a same size as each pixel unit;
the light-shielding portion comprises an opaque cathode which is disposed between and coplanar with the plurality of semi-transparent cathodes; and
the light-transmitting region is a hollow region penetrating through the opaque cathode or is formed by filling the hollow region with a fully transparent material.

7. The display screen of any of claims 2-5, wherein
each semi-transparent cathode has a size larger than a pixel unit corresponding to the semi-transparent cathode;
the light-shielding portion is stacked on a surface of an edge region of the semi-transparent cathode, the edge region being a region beyond a projection region of the pixel unit on the semi-transparent cathode;
the edge region extends according to arrangement positions of metal traces that need to be shielded; and
the light-transmitting region is surrounded by the light-shielding portion and the semi-transparent cathode stacked with the light-shielding portion.

8. The display screen of claim 7, wherein
the light-shielding portion is disposed on a surface of the edge region of the semi-transparent cathode close to the pixel unit; or
the light-shielding portion is disposed on a surface of the edge region of the semi-transparent cathode away from the pixel unit.

9. The display screen of claim 7, wherein the light-shielding portion is disposed on two opposite surfaces of the edge region of the semi-transparent cathode.

10. The display screen of claim 7, wherein the light-shielding portion is formed on the surface of the edge region of the semi-transparent cathode via evaporation.

11. The display screen of claim 7, wherein the light-shielding portion is made of an opaque material or a semi-transparent material.

12. An electronic device comprising a display screen, wherein the display screen comprises:
a metal anode layer, comprising a plurality of metal anodes arranged at intervals;
a semi-transparent cathode layer, comprising a plurality of semi-transparent cathodes; and
a pixel unit layer, sandwiched between the metal anode layer and the semi-transparent cathode layer, wherein the pixel electrode layer comprises a plurality of pixel units arranged at intervals, and each pixel unit is located between a corresponding metal anode and a corresponding semi-transparent cathode;
in a preset region of the display screen, the semi-transparent cathode layer further comprises a light-shielding portion and a light-transmitting region surrounded by the light-shielding portion, the light-shielding portion being disposed between or on the plurality of semi-transparent cathodes.

13. The electronic device of claim 12, wherein the light-transmitting region is hollow or made of a fully transparent material.

14. The electronic device of claim 13, wherein
in the preset region of the display screen, the light-shielding portion is disposed between or on adjacent semi-transparent cathodes, and the light-shielding portion disposed between or on the adjacent semi-transparent cathodes surrounds a light-transmitting region; and
the semi-transparent cathode layer comprises a plurality of light-transmitting regions in the preset region.

15. The electronic device of claim 14, wherein the light-shielding portion between or on the adjacent semi-transparent cathodes is used to shield metal traces around the pixel units corresponding to the semi-transparent cathodes.

16. The electronic device of claim 15, wherein
the light-shielding portion extends to shield a metal-trace region around corresponding pixel units and further extends to have a boundary line in a specific shape, and the light-transmitting region is surrounded by the boundary line and has the specific shape; or
the light-shielding portion extends to exactly shield the metal-trace region around the corresponding pixel units, and the light-transmitting region is a region with edges of the metal-trace region as a boundary line.

17. The electronic device of any of claims 13-16, wherein
each semi-transparent cathode has a same size as each pixel unit;
the light-shielding portion comprises an opaque cathode which is disposed between and coplanar with the plurality of semi-transparent cathodes; and
the light-transmitting region is a hollow region penetrating through the opaque cathode or is formed by filling the hollow region with a fully transparent material.

18. The electronic device of any of claims 13-16, wherein
each semi-transparent cathode has a size larger than a pixel unit corresponding thereto;
the light-shielding portion is stacked on a surface of an edge region of the semi-transparent cathode, the edge region being a region beyond a projection region of the pixel unit on the semi-transparent cathode;
the edge region extends according to arrangement positions of metal traces that need to be shielded; and
the light-transmitting region is surrounded by the light-shielding portion and the semi-transparent cathode stacked with the light-shielding portion.

19. The electronic device of claim 18, wherein
the light-shielding portion is disposed on a surface of the edge region of the semi-transparent cathode close to the pixel unit; or
the light-shielding portion is disposed on a surface of the edge region of the semi-transparent cathode away from the pixel unit.

20. The electronic device of claim 18, wherein the light-shielding portion is disposed on two opposite surfaces of the edge region of the semi-transparent cathode.
